# EUROPEAN PATENT SPECIFICATION

(11) **EP 3 781 328 B1**
(45) Date of publication and mention of the grant of the patent: **15.06.2022**
(21) Application number: 19730674.9
(22) Date of filing: 18.04.2019
(51) Int. Cl.: B05D 5/06, B05D 7/02, B05D 3/06, B05D 3/14, C23C 14/08, C23C 14/00, C23C 14/02, C23C 14/20, C23C 14/10

(54) **CHROME-LOOK PVD LAYER WITH IMPROVED ADHESION**
PVD-SCHICHT MIT CHROMOPTIK UND VERBESSERTER HAFTUNG
COUCHE PVD D'ASPECT CHROMÉ À ADHÉRENCE AMÉLIORÉE

(30) Priority: 19.04.2018 CH 5062018
(43) Date of publication of application: 24.02.2021
(73) Proprietor: Oerlikon Surface Solutions AG, Pfäffikon, 8808 Pfäffikon (CH)
(72) Inventor: MUELLER, Arnd, 7208 Malans (CH)
(74) Representative: Misselhorn, Hein-Martin
(86) International application number: PCT/EP2019/000126
(87) International publication number: WO 2019/201473

(56) References cited:
- WO-A1-2016/166212
- US-A1- 2010 104 786

## Description

Chrome plating has been a common way to manufacture shiny surfaces on plastic parts. An alternative to this environmentally harmful technique is a physical vapor deposition (PVD) process to obtain a similar effect on plastic substrates by i.e. sputtering or evaporating thin metallic layers onto the substrates. Since these PVD coatings are significantly thinner than traditional chrome plating coatings in some cases an additional base coat between substrate and PVD layer is required to level imperfections of the, in most cases injection molded, plastic parts. In addition, a top coat may be applied to protect the thin metallic coating and to adjust the gloss level of the coating system.

The prior art document WO2016/166212 discloses a process for coating a plastic part wherein the plastic part is first coated with a UV curing coating, a metallic PVD layer is then deposited on the UV cured first layer and on top of the metallic layer a UV curable topcoat is deposited. The toplayer is then cured with UV.

Adhesion of the PVD coating towards the substrate or the organic base coat is always an issue and needs to be addressed. Typically a plasma treatment prior to PVD process is carried out to clean and activate the surface but this might not be sufficient to enable the part to withstand the demanding long term stability requirements of the automotive industry.

A pure PVD chromium layer also tends to crack at a certain coating thickness due to its high tensile stress. This improves the adhesion but is still unwanted due to the bad optical appearance of this effect. To avoid cracking of the chrome-looking PVD layer and also improve adhesion a multilayer system can be used, which reduces the intrinsic stress of the complete PVD coating system.

It is also known that the adding of oxygen gas to an argon gas based sputter process can produce well adhering Chromium(III)oxide (Cr2O3).

The present invention describes a new PVD layer structure that significantly improves adhesion of PVD layers embedded in UV cured organic lacquers on plastic substrates by using the metalloide silicon, deposited in a low oxygen partial pressure atmosphere to achieve siliconmonoxide (SiO) as an adhesion promoting layer.

From optical coatings on polymethylmethacrylates (PMMA) it is known that a thin silicon monoxide (SiO) layer of only a few nanometers in thickness can improve adhesion of dielectric antireflection coatings consisting of low refractive silicon dioxide (SiO2) and high refractive index titanium dioxide (TiO2) significantly. This is probably due to the protection of the PMMA by a shielding of UV light by the non-transparent SiO layer. Solid SiO is e-beam evaporated from a crucible and deposited on the PMMA. Especially the UV light from the e-beam gun is blocked but the light transparency in the visible range is barely affected.

Surprisingly the inventors found that such a SiO layer also improves the adhesion of metallic layers on various organic substrates drastically. Since the light transparency is not an issue for chrome-looking parts the thickness of the SiO layer is not limited to some few nanometers in that case. For semi-transparent metallic coatings (so-called translux coatings) with an even thinner PVD coating the SiO layer can be made thin enough in a way that the light transmission is not affected significantly.

A plastic substrate (i.e. ABS, PC/ABS, PC) is coated with an organic base coat and the lacquer is cured by means of UV light. After this the substrate is transferred into vacuum and pre-treated with a plasma.

After this plasma treatment with Argon or a mixture of Argon and reactive gases like oxygen and nitrogen an SiO adhesion layer is deposited onto the surface. This can be for example done by sputtering pure silicon in an oxygen atmosphere or by sputtering a SiO target. When using pure silicon the oxygen flow is reduced after the deposition of the SiO layer and the silicon is sputtered in pure Argon atmosphere to prevent the target from poisoning.

On top of the adhesion layer additional metallic or metal-oxy-nitrides may be applied to generate different colors. Finally the substrate is transferred back to atmosphere and a UV curable top coat lacquer is applied in the same way as the base coat.

The following drawings show some typical examples of layer structures containing the new SiO adhesion layer.

A coated plastic component was disclosed with a plastic substrate and a coating on the plastic substrate to provide for a metallic look. The coating comprises a metallic layer and an adhesion layer between the metallic layer and the plastic substrate where the adhesion layer comprises silicon monoxide to promote adhesion between the metallic layer and an organic material.

The organic material can be the plastic substrate or the organic material can be an organic base coat layer between the plastic substrate and the adhesion layer.

It is possible that on the coating there is a transparent organic top coat layer.

The coating can be a PVD coating.

The coating may comprise a silicon layer which is coated on top of the adhesion layer and preferably the silicon monoxide layer does not form a discrete interface to the silicon layer but forms a gradient with decreasing amount of oxygen.

The coating can comprise different metallic layers, preferably chromium and/or zirconium and/or aluminum and preferably comprises silicon

References:
1 plastic substrate
2 UV cured base coat
3 SiO silicon monoxide layer
4 Si silicon layer
5 Zr zirconium layer
6 Cr chromium layer
7 UV cured transparent top coat

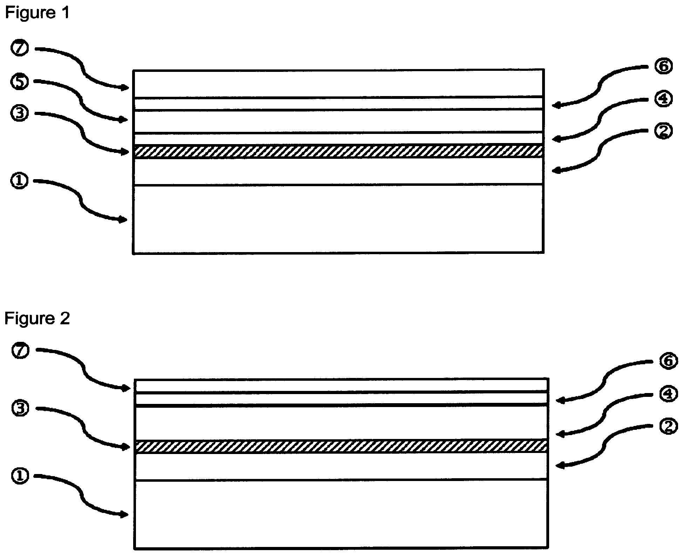

## Claims

1. A coated plastic component with a plastic substrate and a coating on the plastic substrate to provide for a chrome-look, **characterized in that** the coating comprises a metallic layer and an adhesion layer between the metallic layer and the plastic substrate where the adhesion layer comprises silicon monoxide to promote adhesion between the metallic layer and an organic base coat layer, wherein the organic base layer is a lacquer cured by means of UV light.

2. A coated plastic component according to claim 1 characterized that on the coating there is an organic transparent top coat layer.

3. A coated plastic component according to claim 2 characterized that the organic top coat layer is a UV curable layer.

4. A coated plastic component according to claim 3 characterized that the UV curable layer is applied the same way as the base coat.

5. A coated plastic component according to one of the claims 1 to 4 **characterized in that** the coating is a PVD coating.

6. A coated plastic component according to one of the claims 1 to 4 **characterized in that** the coating comprises a silicon layer which is coated on top of the adhesion layer and where preferably the silicon monoxide layer does not form a discrete interface to the silicon layer but forms a gradient with decreasing amount of oxygen.

7. A coated plastic component according to one of the previous claims **characterized in that** the coating comprises different metallic layers, preferably chromium and/or zirconium and/or aluminum and preferably comprises silicon

## Patentansprüche

1. Beschichtetes Kunststoffbauteil mit einem Kunststoffsubstrat und einer Beschichtung auf dem Kunststoffsubstrat zur Bereitstellung einer Chromoptik, **dadurch gekennzeichnet, dass** die Beschichtung eine Metallschicht und eine Haftschicht zwischen der Metallschicht und dem Kunststoffsubstrat umfasst, wobei die Haftschicht Siliziummonoxid umfasst, um die Haftung zwischen der Metallschicht und einer organischen Basisschicht zu fördern, wobei die organische Basisschicht ein mittels UV-Licht gehärteter Lack ist.

2. Beschichtetes Kunststoffbauteil nach Anspruch 1, **dadurch gekennzeichnet, dass** auf der Beschichtung eine organische transparente Deckschicht vorhanden ist.

3. Beschichtetes Kunststoffbauteil nach Anspruch 2, **dadurch gekennzeichnet, dass** die organische Deckschicht eine UV-härtbare Schicht ist.

4. Beschichtetes Kunststoffbauteil nach Anspruch 3, **dadurch gekennzeichnet, dass** die UV-härtbare Schicht auf die gleiche Weise aufgetragen wird wie die Basisschicht.

5. Beschichtetes Kunststoffbauteil nach einem der Ansprüche 1 bis 4, **dadurch gekennzeichnet, dass** die Beschichtung eine PVD-Beschichtung ist.

6. Beschichtetes Kunststoffbauteil nach einem der Ansprüche 1 bis 4, **dadurch gekennzeichnet, dass** die Beschichtung eine Siliziumschicht umfasst, die auf die Haftschicht aufgetragen ist und wobei die Siliziummonoxidschicht vorzugsweise keine separate Grenzschicht zur Siliziumschicht bildet, sondern eine Gradientenschicht mit abnehmender Sauerstoffmenge.

7. Beschichtetes Kunststoffbauteil nach einem der vorhergehenden Ansprüche, **dadurch gekennzeichnet, dass** die Beschichtung aus unterschiedlichen Metallschichten besteht, vorzugsweise aus Chrom und/oder Zirkonium und/oder Aluminium und vorzugsweise Silizium enthält.

## Revendications

1. Composant en matière plastique revêtu avec un substrat en matière plastique et un revêtement sur le substrat en matière plastique pour fournir un aspect chromé, **caractérisé en ce que** le revêtement comprend une couche métallique et une couche adhésive entre la couche métallique et le substrat en matière plastique, la couche adhésive comprenant du monoxyde de silicium pour favoriser l'adhérence entre la couche métallique et une couche de revêtement de base organique, la couche de base organique étant un vernis durci au moyen d'une lumière UV.

2. Composant en matière plastique revêtu selon la revendication 1, **caractérisé en ce qu'**une couche de protection organique transparente se trouve sur le revêtement.

3. Composant en matière plastique revêtu selon la revendication 2, **caractérisé en ce que** la couche de protection organique est une couche durcissable aux UV.

4. Composant en matière plastique revêtu selon la revendication 3, **caractérisé en ce que** la couche durcissable aux UV est appliquée de la même manière que la couche de base.

5. Composant en matière plastique revêtu selon l'une des revendications 1 à 4 **caractérisé en ce que** le revêtement est un revêtement PVD.

6. Composant en matière plastique revêtu selon l'une des revendications 1 à 4 **caractérisé en ce que** le revêtement comprend une couche de silicium qui est déposée au-dessus de la couche adhésive et de préférence la couche de monoxyde de silicium ne forme pas une couche d'interface séparée de la couche de silicium mais forme une couche à gradient avec une quantité décroissante d'oxygène.

7. Composant en matière plastique revêtu selon l'une des revendications précédentes **caractérisé en ce que** le revêtement comprend différentes couches métalliques, de préférence du chrome et/ou du zirconium et/ou de l'aluminium et comprend de préférence du silicium.
